(19) Europäisches Patentamt
European Patent Office
Office européen des brevets

(11) **EP 3 136 528 B1**

(12) **EUROPÄISCHE PATENTSCHRIFT**

(45) Veröffentlichungstag und Bekanntmachung des Hinweises auf die Patenterteilung:
**22.04.2020 Patentblatt 2020/17**

(51) Int Cl.:
*H02H 3/30* (2006.01)　　　　*G01R 31/08* (2020.01)
*H02H 7/26* (2006.01)　　　　*H04L 7/00* (2006.01)
*H02H 1/00* (2006.01)

(21) Anmeldenummer: **15183104.7**

(22) Anmeldetag: **31.08.2015**

(54) **DIFFERENTIALSCHUTZVERFAHREN, DIFFERENTIALSCHUTZEINRICHTUNG UND DIFFERENTIALSCHUTZSYSTEM**

DIFFERENTIAL PROTECTION METHOD, DIFFERENTIAL PROTECTION DEVICE AND DIFFERENTIAL PROTECTION SYSTEM

PROCEDE DE PROTECTION DIFFERENTIELLE, DISPOSITIF DE PROTECTION DIFFERENTIELLE ET SYSTEME DE PROTECTION DIFFERENTIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.03.2017 Patentblatt 2017/09**

(73) Patentinhaber: **Siemens Aktiengesellschaft 80333 München (DE)**

(72) Erfinder:
• **KERGER, Torsten 14621 Schönwalde-Glien (DE)**
• **MATUSSEK, Robert 10249 Berlin (DE)**

(56) Entgegenhaltungen:
**EP-A1- 2 618 502　　US-A1- 2011 069 421
US-B2- 6 571 182　　US-B2- 8 791 730**

## Beschreibung

Die Erfindung betrifft ein Differentialschutzverfahren zum Überwachen einer Leitung eines elektrischen Energieversorgungsnetzes, bei dem an den Enden der Leitung jeweils mit Messeinrichtungen Stromzeigermesswerte erfasst werden, die Amplitude und Phasenwinkel eines an dem jeweiligen Ende der Leitung fließenden Phasenstroms angeben, wobei die Messeinrichtungen lokale Zeitgeber aufweisen und den Stromzeigermesswerten einen den Zeitpunkt ihrer Erfassung angebenden Zeitstempel zuordnen, zumindest die an einem Ende erfassten Stromzeigermesswerte über eine Kommunikationsverbindung zu einer Auswerteeinrichtung übertragen werden, mittels der Auswerteeinrichtung mit zeitlich einander zugeordneten Stromzeigermesswerten durch vektorielle Addition ein Differenzstromwert gebildet wird, wobei zur zeitlichen Zuordnung der an unterschiedlichen Enden erfassten Stromzeigermesswerte eine den Zeitversatz zwischen den lokalen Zeitgebern der Messeinrichtungen angebende Zeitversatzinformation herangezogen wird, und ein einen Fehler hinsichtlich der Leitung angebendes Fehlersignal erzeugt wird, wenn der Differenzstromwert einen vorgegebenen Schwellenwert überschreitet.

Die Erfindung betrifft auch eine entsprechende Differentialschutzeinrichtung zur Durchführung eines solchen Differentialschutzverfahrens sowie ein Differentialschutzsystem mit mindestens zwei solchen Differentialschutzeinrichtungen.

Zur Überwachung von Hoch- und Mittelspannungsleitungen, z.B. Freileitungen oder Kabeln, elektrischer Energieversorgungsnetze wird oft ein Strom-Differentialschutzverfahren (nachfolgend der Einfachheit halber als "Differentialschutzverfahren" bezeichnet) eingesetzt. Dabei wird der an den Enden der überwachten Leitung fließende Strom in Form von Stromzeigermesswerten, die eine Information über Amplitude und Phasenwinkel des Stroms angeben, erfasst und einer Differentialschutzeinrichtung zugeführt. Die Differentialschutzeinrichtung bildet durch vektorielle Addition aus den Stromzeigermesswerten Differenzstromwerte, die zur Beurteilung der Betriebssituation der überwachten Primärkomponente herangezogen werden. Hierzu werden die Differenzstromwerte üblicherweise durch vektorielle Addition und anschließende Betragsbildung aus den Stromzeigermesswerten bestimmt. Im fehlerfreien Fall liegen die Differenzstromwerte in einem Bereich nahe Null, da hierbei - vereinfacht gesprochen - der in die Komponente hinein fließende Strom vollständig auch wieder aus ihr heraus fließt. Ergeben sich hingegen Differenzstromwerte, die einen von Null verschiedenen Schwellenwert überschreiten, so lassen diese auf einen fehlerbehafteten Betriebszustand, z.B. einen internen Kurzschluss, schließen. In diesem Fall muss der vorliegende Fehlerstrom durch Öffnen von die Leitung begrenzenden Schalteinrichtungen, z.B. Leistungsschaltern, unterbrochen werden. Hierfür erzeugt die Differentialschutzeinrichtung ein entsprechendes Fehlersignal, wodurch die Erzeugung eines Schaltsignals für die jeweilige Schalteinrichtung veranlasst werden kann.

Bei einer Leitung mit weit auseinander liegenden Enden, beispielsweise einer Leitung von mehreren Kilometern Länge, müssen die Stromzeigermesswerte über eine längere Strecke übertragen werden. In einem solchen Fall ist üblicherweise an jedem der Enden der Leitung eine separate Differentialschutzeinrichtung angeordnet, die den jeweiligen Differenzstromwert aus den eigenen (lokal erfassten) Stromzeigermesswerten und den vom anderen Ende der Leitung empfangenen Stromzeigermesswerten bildet. Bei einer Leitung mit mehreren Enden, z.B. einer verzweigten Leitung, sind zudem Stromzeigermesswerte von jedem der Enden erforderlich, um das Differentialschutzverfahren korrekt durchführen zu können. Dazu müssen die an den jeweiligen Messstellen lokal erfassten Stromzeigermesswerte zwischen den einzelnen Differentialschutzgeräten übertragen werden.

Zur Beurteilung der Betriebssituation der Leitung sind folglich Stromzeigermesswerte von zumindest zwei unterschiedlichen Messstellen an den jeweiligen Enden der überwachten Leitung erforderlich. Bei bestehenden Differentialschutzsystemen werden die Stromzeigermesswerte häufig über eine festverdrahtete Punkt-zu-Punkt-Verbindung (z.B. Kupfer- oder Glasfaserleitungen) übertragen, wodurch eine deterministische Übertragung erreicht wird, d.h., die Übertragungszeit der Messwerte ist hauptsächlich abhängig von der Übertragungsstrecke und der Übertragungsart sowie im Wesentlichen konstant.

Bei jüngeren Differentialschutzsystemen geht man mittlerweile dazu über, die Stromzeigermesswerte anstelle über eine Festverdrahtung über ein Kommunikationsnetzwerk, z.B. ein Telekommunikationsnetzwerk oder ein auf dem IP-Protokoll basierendes Datenkommunikationsnetzwerk, zu übertragen. Dies hat den Vorteil einer kostengünstigeren Kommunikationsinfrastruktur. Außerdem sind Kommunikationsnetzwerke oftmals bereits in der Nähe elektrischer Primärkomponenten, z.B. zwischen sogenannten Unterstationen eines Energieversorgungsnetzes, vorhanden und können ohne zusätzliche Kosten für die Übermittlung der Strommesswerte genutzt werden.

Durch die Nutzung von Kommunikationsnetzwerken zur Übertragung der Strommesswerte verliert man jedoch oftmals den Vorteil der deterministischen Übertragungszeit, so dass ein Problem hinsichtlich der Zuordnung der jeweils zusammengehörenden Stromzeigermesswerte entsteht. Dabei müssen die lokalen und die empfangenen Messwerte nämlich derart zeitlich angeglichen werden, dass bei der Differenzwertbildung jeweils die zu demselben Zeitpunkt erfassten Zeigermesswerte miteinander verglichen werden. Wenn - wie in einem deterministischen Kommunikationssystem möglich - beispielsweise die jeweilige Übertragungszeit der Stromzeigermesswerte bekannt ist, kann der jeweilige Zeitpunkt der Messwerterfassung aus dem Empfangszeitpunkt der Messdaten im lokalen Differentialschutzgerät und der bekannten Übertragungszeit ermittelt werden. Bei Kommunikationssystemen, die hinsichtlich der Übertragungswege und/oder Laufzeiten von Nachrichten nicht deterministisch sind - beispielsweise Telekommunikationsnetzen oder IP- bzw. Ethernet-Netzwerken - ergeben sich hingegen beispielsweise Probleme, weil die Übertragungszeit nicht konstant ist oder Unterschiede der Übertragungszeit in Hin- und Rückrichtung auftreten.

Durch solche Unsicherheiten bei der zeitlichen Angleichung der jeweiligen Stromzeigermesswerte kann eine Überfunktion der Differentialschutzeinrichtung herbeigeführt werden, da bei der vorzeichenrichtigen Addition nicht zusammengehörender Zeigermesswerte ein Differenzstromwert gebildet wird, der einen Fehler hinsichtlich der Primärkomponente vorgibt, der tatsächlich jedoch gar nicht vorhanden ist. Hieraus können Fehlauslösungen resultieren, die den ordnungsgemäßen Betrieb des Energieversorgungsnetzes beeinträchtigen.

Da es für eine zuverlässige Funktionsweise eines Differentialschutzverfahrens somit wesentlich ist, dass die Stromzeigermesswerte an den Leitungsenden zu jeweils gleichen Zeitpunkten ermittelt werden, besitzen die Messeinrichtungen, mit denen die Stromzeigermesswerte an den Leitungsenden erfasst werden, mittlerweile üblicherweise lokale Zeitgeber bzw. Uhren, die ein Zeitsignal abgeben, das zur Zeitstempelung der erfassten Stromzeigermesswerte verwendet wird. Um beispielsweise die Zeigermesswerte zu jeweils gleichen Zeitpunkten bestimmen zu können, ist es notwendig, diese lokalen Zeitgeber zeitlich miteinander zu synchronisieren, so dass der Zeitversatz zwischen den lokalen Zeitgebern auf null geregelt wird. Dies könnte beispielsweise dadurch erreicht werden, dass die lokalen Zeitgeber über ein externes Zeitgebersystem, z.B. durch das im GPS-Signal enthaltene Zeitsignal, miteinander synchronisiert werden. Hierzu sind jedoch spezielle Empfangssysteme, z.B. GPS-Empfänger, notwendig, die sich erhöhend auf den Gerätepreis auswirken. Die Antennen von GPS-Empfängern benötigen zudem eine freie Sicht zu den Satelliten, so dass entsprechende bauliche Voraussetzungen vorliegen oder geschaffen werden müssen.

Ohne externe Mittel wie GPS-Empfänger, wird eine Synchronisation der lokalen Zeitgeber heutzutage häufig unter Verwendung von zwischen den Messeinrichtungen an den Leitungsenden übertragenen Telegrammen durchgeführt. Bei dieser auch als "Ping-Pong-Verfahren" bezeichneten Methode werden die Sende- und Empfangszeitstempel der übertragenen Telegramme zwischen den jeweiligen Messeinrichtungen ausgetauscht. Als Ergebnis dieses Verfahrens erhält man den Zeitversatz zwischen den lokalen Zeitgebern. Damit ist es entweder möglich, die im Zeitstempel des Telegramms enthaltene Zeitinformation der empfangenen Messwerte der jeweils anderen Messeinrichtung in die eigene Zeit umzurechnen, oder durch Anpassung der Uhrzeit eines der Zeitgeber den Zeitversatz auf null zu regeln.

Grundvoraussetzung für dieses Verfahren zur Ermittlung des Zeitversatzes zwischen den Zeitgebern ist allerdings, dass die Laufzeiten der Telegramme bei der Übertragung auf dem Hin- und dem Rückweg gleich sein müssen. In diesem Zusammenhang spricht man von der Gewährleistung von symmetrischen Laufzeiten.

In der Regel gewährleisten Kommunikationsnetzwerke eine hohe Datenqualität, Verfügbarkeit sowie symmetrische Laufzeiten. Trotzdem kann es vorkommen, dass die Voraussetzung von symmetrischen Laufzeiten in einem Kommunikationsnetzwerk nicht komplett sichergestellt werden kann. Beobachtet wurde beispielsweise, dass sich bei einem durch mehrere Kommunikationsnetzwerke oder mehrere Teilnetzwerke eines Kommunikationsnetzwerks verlaufenden Kommunikationspfad der übertragenen Telegramme die Laufzeiten schrittweise in sehr geringen Beträgen erhöhen und dann wiederum plötzlich in großen Sprüngen verringern können. Beobachtet wurde weiterhin, dass sich die Symmetrie der Laufzeiten bei Änderung des Verlaufs des Kommunikationspfades ändert und sich bei Rückkehr auf den ursprünglichen Kommunikationspfad nicht die ursprünglich vorhandenen Laufzeiten einstellen.

Treten unsymmetrische Laufzeiten auf, d.h. die Laufzeiten der Telegramme auf dem Hin- und Rückweg sind nicht gleich, können die empfangenen Stromzeigermesswerte den eigenen Stromzeigermesswerten zeitlich nicht korrekt zugeordnet werden. Es entsteht ein sogenannter "Winkelfehler". In der Folge würde die jeweilige Differentialschutzeinrichtung einen Differenzstromwert bestimmen, der hinsichtlich der überwachten Leitung in der Realität nicht vorhanden ist. Überschreitet dieser Differenzstromwert einen bestimmten Schwellwert, kommt es zur Fehlabschaltung der überwachten Leitung.

Aus der US 8,154,836 B2 ist ein Differentialschutzverfahren bekannt, bei dem in einem Differentialschutzsystem mit mehr als zwei Enden die lokalen Zeitgeber über ein externes Synchronisationsverfahren, z.B. ein GPS-Signal, oder ein leitungsbasiertes Synchronisationsverfahren synchronisiert werden. Auch ein gemischter Einsatz der verschiedenen Verfahren ist möglich. Bei Ausfall eines externen Zeitsignals kann unter bestimmten Voraussetzungen auf das leitungsbasierte Synchronisationsverfahren umgeschaltet werden, so dass die Zeitgeber weiterhin synchron gehalten werden können.

Der Erfindung liegt die Aufgabe zugrunde, eine möglichst kostengünstige Möglichkeit anzugeben, mit der ein Differentialschutzverfahren auch bei Übertragung der Strommesswerte über ein Kommunikationsnetzwerk, bei dem unsymmetrische Laufzeiten auftreten können, möglichst zuverlässig durchgeführt werden kann.

Diese Aufgabe wird durch ein Verfahren gemäß Anspruchs 1 gelöst, bei dem unter Verwendung von zeitlich einander zugeordneten elektrischen Messgrößen, die an unterschiedlichen Enden der Leitung erfasst worden sind, und einem bezüglich der zwischen den Enden verlaufenden Leitung leitungsspezifischen Parameter eine Überprüfung durchgeführt wird, ob die Zeitversatzinformation den tatsächlichen Zeitversatz zwischen den jeweiligen lokalen Zeitgebern angibt, und ein Zeitfehler-Signal erzeugt wird, wenn bei der Überprüfung eine fehlerhafte Zeitversatzinformation erkannt wird.

Ein wesentlicher der Erfindung zugrunde liegender Gedanke besteht darin, die zu Zwecken der zeitlichen Synchronisation herangezogene Zeitversatzinformation, die während des Betriebs der Leitung üblicherweise kontinuierlich ermittelt wird, unter Verwendung elektrischer Messgrößen, die an den Leitungsenden erfasst worden sind, und eines leitungsspezifischen Parameters, der eine Eigenschaft der zwischen den Enden liegenden Leitung angibt, zu überprüfen. Sollte bei der Überprüfung festgestellt werden, dass die Zeitversatzinformation nicht plausibel ist, wird eine entsprechende Meldung in Form des Zeitfehler-Signals erzeugt. Dabei wird vorteilhaft eine Eigenschaft hinsichtlich des eingesetzten Kommunikationssystems unter Verwendung von kommunikationsfremden Größen, nämlich elektrischen Größen der überwachten Leitung (elektrische Messgrößen von den Leitungsenden und leitungsspezifischer Parameter), überprüft.

Als elektrische Messgrößen können beispielsweise Stromzeiger, Spannungszeiger und Lastflüsse (Produkt aus zueinander gehörenden Strom- und Spannungszeigern) verwendet werden. Leitungsspezifische Parameter können beispielsweise ein Ladestrom, eine Leitungslänge und/oder eine Ausbreitungskonstante sein.

Konkret ist erfindungsgemäß vorgesehen, dass zur Überprüfung der Zeitversatzinformation unter Verwendung der elektrischen Messgrößen und des leitungsspezifischen Parameters ein Vergleichs-Phasenwinkel ermittelt wird und der Vergleichs-Phasenwinkel zur Überprüfung der Zeitversatzinformation herangezogen wird.

Gemäß des erfindungsgemäßen Verfahrens wird somit aus den Informationen über die elektrischen Messgrößen sowie dem leitungsspezifischen Parameter ein Vergleichs-Phasenwinkel ermittelt.

Hierzu kann gemäß einer weiteren vorteilhaften Ausführungsform des erfindungsgemäßen Verfahrens vorgesehen sein, dass der Vergleichs-Phasenwinkel ermittelt wird, indem die zeitlich einander zugeordneten elektrischen Messgrößen um den Betrag des leitungsspezifischen Parameters aufgespannt werden und der zwischen den aufgespannten Amplituden liegende Winkel als Vergleichs-Phasenwinkel verwendet wird.

Beispielsweise kann gemäß einer vorteilhaften Ausführungsform des erfindungsgemäßen Verfahrens vorgesehen sein, dass als elektrische Messgrößen, die an unterschiedlichen Enden der Leitung erfasst worden sind, Amplituden von zeitlich einander zugeordneten Stromzeigermesswerten verwendet werden, und als leitungsspezifischer Parameter ein den Ladestrom bezüglich der zwischen den Enden verlaufenden Leitung angebender Ladestromwert verwendet wird. Dies soll nachfolgend beispielhaft näher erläutert werden.

Im fehlerfreien Betrieb der Leitung entspricht der in die Leitung hineinfließende Strom der Summe des aus der Leitung abfließenden Stroms und des durch die Kapazität der Leitung bewirkten Ladestroms. Aus den Amplituden der Stromzeigermesswerte und dem Betrag des Ladestromwertes muss sich folglich durch vektorielle Addition ein Vergleichs-Phasenwinkel ermitteln lassen, der zur Überprüfung der Zeitversatzinformation herangezogen werden kann.

Dabei werden zur Plausibilitätsprüfung die von dem Zeitversatz der Zeitgeber grundsätzlich nicht beeinflussten Amplituden der Stromzeigermesswerte herangezogen und die Information Phasenwinkel außen vor gelassen.

Der Ladestromwert wird durch den Betreiber des die überwachte Leitung umfassenden Energieversorgungsnetzes als leitungsspezifischer Parameter in der Differentialschutzeinrichtung eingegeben. Dabei ist der Ladestrom von Größen wie der Nennspannung, der Länge der Leitung und ihrem kapazitiven Belag abhängig. Konkret kann der Ladestromwert wie folgt berechnet werden:

$$I_C = F \cdot U_N \cdot f_N \cdot C_B{}' \cdot s,$$

mit

$I_C$: zu ermittelnder Ladestromwert [A];

$F$: Faktor ($\frac{2\pi}{\sqrt{3}} \cdot 10^{-6}$, etwa $3{,}63 \cdot 10^{-6}$);

$U_N$: Nennspannung des Energieversorgungsnetzes [kV];

$F_N$: Nennfrequenz des Energieversorgungsnetzes [Hz];

$C_B{}'$: kapazitiver Belag der Leitung [nF/km];

$s$: Länge der Leitung [km].

Hierbei wird somit aus den Informationen über die Amplituden der verwendeten Stromzeigermesswerte sowie dem Betrag des Ladestromwertes ein Vergleichs-Phasenwinkel ermittelt. Dem liegt die Erkenntnis zugrunde, dass im fehlerfreien Betrieb der Leitung im Idealfall der in die Leitung hineinfließende Strom der Summe des aus der Leitung abfließenden Stroms und des durch die Kapazität der Leitung bewirkten Ladestroms entsprechen muss. Aus den Amplituden der Stromzeigermesswerte und dem Betrag des Ladestromwertes muss sich folglich durch vektorielle Addition ein Vergleichs-Phasenwinkel ermitteln lassen, der zur Überprüfung der Zeitversatzinformation herangezogen werden kann.

Hierbei wird der Vergleichs-Phasenwinkel ermittelt indem die Amplituden der zeitlich einander zugeordneten Stromzeigermesswerte um den Betrag des Ladestromwerts aufgespannt werden und der zwischen den aufgespannten Amplituden liegende Winkel als Vergleichs-Phasenwinkel verwendet.

Bildlich gesprochen wird hierbei quasi ein Dreieck konstruiert, dessen Seiten einerseits durch die Amplituden der beiden verwendeten Stromzeigermesswerte und andererseits durch den Betrag des Ladestromwertes gebildet werden. Der zwischen den beiden Amplituden liegende Winkel stellt den gesuchten Vergleichs-Phasenwinkel dar.

Prinzipiell arbeitet das erfindungsgemäße Verfahren bei dieser Ausführungsform damit wie nachfolgend dargestellt. Als Eingangsgrößen werden folgende physikalische Größen benötigt:

- Amplitude des Stromzeigers $I_1$ am Leitungsende 1;
- Amplitude des Stromzeigers $I_2$ am Leitungsende 2;
- Betrag des Ladestromes $I_c$;
- Zeitversatz-Information aus kontinuierlicher Ermittlung.

Dazu werden die Amplituden der Ströme $I_1$ und $I_2$ mit den Messeinrichtungen an beiden Leitungsenden gemessen und der Differentialschutzeinrichtung über die Kommunikationsverbindung bereitgestellt.

Aus den beiden Amplituden und dem Betrag des Ladestroms lässt sich im fehlerfreien Betrieb der Leitung ein Dreieck bilden. Dabei ist es für diesen Schritt des Verfahrens unwesentlich, welchen absoluten Phasenwinkel die Stromzeiger haben, daher wird ausschließlich die Amplitude berücksichtigt. Durch die Kenntnis der Amplituden lässt sich das Dreieck konstruieren und der Winkel zwischen den Amplituden bestimmen. Anschließend kann der sich ergebende Winkel mit dem Zeitversatz aus der kontinuierlichen Überwachung der Zeitgeber verglichen werden. Aus einer etwaigen Differenz kann darauf geschlossen werden, dass die Zeitversatz-Information - z.B. aufgrund einer Unsymmetrie hinsichtlich der Datenübertragung auf dem Kommunikationskanal - als nicht plausibel anzusehen ist und es daher Probleme mit der Ermittlung des Differenzstromwertes geben könnte.

Alternativ zur Verwendung von Stromzeigermesswerten und dem Ladestromwert kann auch vorgesehen sein, dass als elektrische Messgrößen, die an unterschiedlichen Enden der Leitung erfasst worden sind, zeitlich einander zugeordnete Spannungszeigermesswerte verwendet werden und als leitungsspezifischer Parameter die Leitungslänge und/oder die Ausbreitungskonstante bezüglich der zwischen den Enden verlaufenden Leitung verwendet wird, oder dass als elektrische Messgrößen, die an unterschiedlichen Enden der Leitung erfasst worden sind, zeitlich einander zugeordnete Produkte von Strom- und Spannungszeigermesswerte verwendet werden und als leitungsspezifischer Parameter die Leitungslänge und/oder die Ausbreitungskonstante bezüglich der zwischen den Enden verlaufenden Leitung verwendet wird.

Die Überprüfung der Zeitversatzinformation erfolgt in diesen Fällen prinzipiell entsprechend zu dem bereits ausführlich beschriebenen Beispiel, bei dem Stromzeigermesswerte und der Ladestromwert verwendet werden.

Um die durch den Vergleichs-Phasenwinkel angegebene Winkelinformation mit der eine Zeit angebenden Zeitversatzinformation vergleichen zu können, müssen Winkel und Zeit ineinander umgerechnet werden. Diese Umrechnung kann bei - z.B. durch Messung - bekannter aktueller Frequenz f des Energieversorgungsnetzes einfach über die hieraus bekannte Kreisfrequenz $\omega = 2\pi \cdot f$ durchgeführt werden.

Konkret kann gemäß einer ersten vorteilhaften Ausführungsform in diesem Zusammenhang vorgesehen sein, dass zur Überprüfung der Zeitversatzinformation ein sich aus der Zeitversatzinformation ergebender Zeitversatz-Phasenwinkel ermittelt wird, der Zeitversatz-Phasenwinkel mit dem Vergleichs-Phasenwinkel verglichen wird, und bei einer vorliegenden Abweichung zwischen dem Zeitversatz-Phasenwinkel und dem Vergleichs-Phasenwinkel das Zeitfehler-Signal erzeugt wird.

Gemäß dieser ersten Ausführungsform wird somit die Zeitversatzinformation in eine Winkelinformation umgerechnet und der Vergleich unter Verwendung von Winkeln durchgeführt.

Gemäß einer alternativen vorteilhaften Ausführungsform kann vorgesehen sein, dass zur Überprüfung der Zeitversatzinformation eine sich aus dem Vergleichs-Phasenwinkel ergebende Vergleichs-Zeitversatzinformation ermittelt wird, die Vergleichs-Zeitversatzinformation mit der Zeitversatzinformation verglichen wird, und bei einer vorliegenden Abweichung zwischen der Vergleichs-Zeitversatzinformation und der Zeitversatzinformation das Zeitfehler-Signal erzeugt wird.

Gemäß dieser alternativen Ausführungsform wird somit die Winkelinformation in eine Zeitinformation umgerechnet und der Vergleich unter Verwendung von Zeitgrößen durchgeführt.

Hinsichtlich beider Alternativen kann zudem vorgesehen sein, dass das Zeitfehler-Signal nur dann erzeugt wird, wenn die Abweichung einen vorgegebenen Toleranz-Schwellenwert überschreitet.

Hierdurch kann insbesondere für den praktischen Einsatz des Verfahrens die Tatsache Berücksichtigung finden, dass sich eine vollständige Übereinstimmung der beiden Winkelinformationen bzw. Zeitgrößen aufgrund von Mess- und Berechnungsungenauigkeiten in der Regel nicht einstellen wird. Durch geeignete Wahl eines Toleranz-Schwellenwertes kann erreicht werden, dass leichte Abweichungen nicht zu einer Erzeugung des Zeitfehler-Signals führen.

Bei einer nicht zutreffenden Angabe der Zeitversatz-Information kann die korrekte Auswahl zeitlich zueinander gehörender Stromzeigermesswerte für die Bildung des Differenzstromwertes nicht mehr gewährleistet werden. Somit sind bei Vorliegen des Zeitfehler-Signals geeignete Maßnahmen zu treffen, um eine ungewollte Abschaltung der überwachten Leitung zu vermeiden.

Hierzu kann gemäß einer ersten vorteilhaften Ausführungsform des erfindungsgemäßen Verfahrens vorgesehen sein, dass bei vorliegendem Zeitfehler-Signal die Abgabe des Fehlersignals blockiert wird.

Auf diese Weise kann die Abgabe eines Fehlersignals und damit die Auslösung von Schalteinrichtungen zur Abschaltung der Leitung vollständig verhindert werden.

Gemäß einer alternativen Ausführungsform kann in diesem Zusammenhang auch vorgesehen sein, dass bei vorliegendem Zeitfehler-Signal der Wert des zur Bewertung des Differenzstromwertes verwendeten Schwellenwertes erhöht wird.

Hierdurch kann in geeigneter Weise die Empfindlichkeit des Differentialschutzverfahrens reduziert werden, um Ungenauigkeiten bei der Ermittlung des Differenzstromwertes, die auf die fehlerhafte Zeitversatz-Information zurückzuführen sind, durch Heraufsetzung des Schwellenwertes zu kompensieren. Gemäß dieser Ausführungsform kann bei besonders hohen Werten des Differenzstromwertes, die mit hoher Wahrscheinlichkeit auf einen Fehler auf der Leitung zurückzuführen sind, trotz vorliegendem Zeitfehler-Signal eine Abschaltung der Leitung erfolgen.

Gemäß einer weiteren vorteilhaften Ausführungsform des erfindungsgemäßen Verfahrens kann vorgesehen sein, dass die Zeitversatzinformation derart ermittelt wird, dass über die Kommunikationsverbindung Nachrichten übertragen werden und zur Ermittlung der Zeitversatzinformation der halbe Wert der Zeitdauer der Übertragung einer ersten Nachricht in die eine Übertragungsrichtung und einer zweiten Nachricht in die andere Übertragungsrichtung verwendet wird.

Dieses oben bereits erwähnte Ping-Pong-Verfahren eignet sich bei symmetrischen Kommunikationsstrecken besonders gut zur Ermittlung der Zeitversatz-Information, da es einfach und damit kostengünstig durchgeführt werden kann. Eine sich plötzlich oder schleichend einstellende Unsymmetrie der Kommunikationsstrecke, also voneinander verschiedene Laufzeiten der Telegramme auf dem Hin- und dem Rückweg, lassen sich über das oben dargestellte Verfahren leicht ermitteln, so dass nicht plausible Werte der Zeitversatz-Information erkannt werden können.

Alternativ zum Ping-Pong-Verfahren können jedoch auch andere geeignete Verfahren zur Bestimmung der Zeitversatz-Information herangezogen werden, beispielsweise eine Bestimmung entsprechend des PTP-Standards IEEE 1588 (Precision Time Protocol).

Um das erfindungsgemäße Verfahren auch bei Leitungen mit mehr als zwei Enden, beispielsweise verzweigten Leitungen, einsetzen zu können, wird gemäß einer weiteren vorteilhaften Ausführungsform des erfindungsgemäßen Verfahrens schließlich vorgeschlagen, dass bei einer mehr als zwei Enden aufweisenden Leitung die Überprüfung, ob die Zeitversatzinformation den tatsächlichen Zeitversatz zwischen den jeweiligen lokalen Zeitgebern angibt, für jeweils zwei Enden unter Verwendung des Ladestromwertes hinsichtlich des zwischen diesen Enden liegenden Leitungsabschnitts durchgeführt wird.

Mit dem beschriebenen Verfahren und seinen vorteilhaften Ausführungsformen ist es möglich, das Entstehen einer unsymmetrischen Kommunikationsstrecke und dadurch bewirkte Ungenauigkeiten bei der Ermittlung der Zeitversatzinformation festzustellen und zu melden. Das Netzwerkmanagement des Kommunikationsnetzes selbst ist dazu oftmals nicht eingerichtet. Ein besonderer Vorteil besteht darin, dass die Erkennung einer fehlerhaften Zeitversatzinformation ohne den Einsatz zusätzlicher technischer Einrichtungen erfolgen kann. Mit dem beschriebenen Verfahren können z.B. Fehlauslösungen des Differentialschutzes, verursacht durch nicht erkannte Laufzeitänderungen, verhindert werden.

Die oben genannte Aufgabe wird auch durch eine Differentialschutzeinrichtung zum Überwachen einer Leitung eines elektrischen Energieversorgungsnetzes gelöst. Die Differentialschutzeinrichtung umfasst eine einen lokalen Zeitgeber aufweisende Messeinrichtung, die dazu eingerichtet ist, an einem Ende der Leitung Stromzeigermesswerte zu erfassen, die Amplitude und Phasenwinkel eines an dem Ende der Leitung fließenden Phasenstroms angeben, und den Stromzeigermesswerten einen den Zeitpunkt ihrer Erfassung angebenden Zeitstempel zuzuordnen. Außerdem umfasst die Differentialschutzeinrichtung eine Kommunikationseinrichtung, die dazu eingerichtet ist, Stromzeigermesswerte über eine Kommunikationsstrecke mit einer anderen Differentialschutzeinrichtung auszutauschen, und eine Auswerteeinrichtung, die dazu eingerichtet ist, mit zeitlich einander zugeordneten eigenen Stromzeigermesswerten einerseits und von der anderen Differentialschutzeinrichtung empfangenen Stromzeigermesswerten andererseits durch vorzeichenrichtige Addition einen Differenzstromwert zu bilden, wobei zur zeitlichen Zuordnung der an unterschiedlichen Enden erfassten Stromzeigermesswerte eine den Zeitversatz zwischen den lokalen Zeitgebern der Messeinrichtungen der Differentialschutzeinrichtungen angebende Zeitversatzinformation herangezogen wird, und ein einen Fehler hinsichtlich der Leitung angebendes Fehlersignal zu erzeugen, wenn der Differenzstromwert einen vorgegebenen Schwellenwert überschreitet.

Erfindungsgemäß ist vorgesehen, dass die Differentialschutzeinrichtung dazu eingerichtet ist, unter Verwendung von zeitlich einander zugeordneten eigenen Messgrößen einerseits und von der anderen Differentialschutzeinrichtung empfangenen Messgrößen andererseits und einem leitungsspezifischen Parameter eine Überprüfung durchzuführen, ob die Zeitversatzinformation den tatsächlichen Zeitversatz zwischen den jeweiligen lokalen Zeitgebern angibt, und ein Zeitfehler-Signal zu erzeugen, wenn bei der Überprüfung eine fehlerhafte Zeitversatzinformation erkannt wird.

Die oben genannte Aufgabe wird schließlich auch durch ein Differentialschutzsystem zum Überwachen einer Leitung eines elektrischen Energieversorgungsnetzes nach Anspruch 13 gelöst. Das Differentialschutzsystem umfasst zumindest zwei Differentialschutzeinrichtungen, wobei an jedem Ende der Leitung eine Differentialschutzeinrichtung vorgesehen ist, und eine Kommunikationsverbindung, mit der die einzelnen Differentialschutzeinrichtungen zur Übertragung von Stromzeigermesswerten in Verbindung stehen. Jede der Differentialschutzeinrichtungen des Differentialschutzsystems umfasst eine einen lokalen Zeitgeber aufweisenden Messeinrichtung, die dazu eingerichtet ist, an einem jeweiligen Ende der Leitung Stromzeigermesswerte zu erfassen, die Amplitude und Phasenwinkel eines an dem Ende der Leitung fließenden Phasenstroms angeben, und den Strommesswerten einen den Zeitpunkt ihrer Erfassung angebenden Zeitstempel zuzuordnen. Außerdem umfasst jede Differentialschutzeinrichtung eine Kommunikationseinrichtung, die dazu eingerichtet ist, Stromzeigermesswerte über eine Kommunikationsstrecke mit einer anderen Differentialschutzeinrichtung auszutauschen. Zumindest eine der Differentialschutzeinrichtungen des Differentialschutzsystems umfasst zudem eine Auswerteeinrichtung, die dazu eingerichtet ist, mit zeitlich einander zugeordneten eigenen Stromzeigermesswerten einerseits und von der anderen Differentialschutzeinrichtung empfangenen Stromzeigermesswerten andererseits durch vorzeichenrichtige Addition einen Differenzstromwert zu bilden, wobei zur zeitlichen Zuordnung der an unterschiedlichen Enden erfassten Stromzeigermesswerte eine den Zeitversatz zwischen den lokalen Zeitgebern der Messeinrichtungen der Differentialschutzeinrichtungen angebende Zeitversatzinformation herangezogen wird, und ein einen Fehler hinsichtlich der Leitung angebendes Fehlersignal zu erzeugen, wenn der Differenzstromwert einen vorgegebenen Schwellenwert überschreitet.

Erfindungsgemäß ist vorgesehen, dass die zumindest eine der Differentialschutzeinrichtungen dazu eingerichtet ist, unter Verwendung von zeitlich einander zugeordneten eigenen elektrischen Messgrößen einerseits und von der anderen Differentialschutzeinrichtung empfangenen elektrischen Messgrößen andererseits und einem leitungsspezifischen Parameter eine Überprüfung durchzuführen, ob die Zeitversatzinformation den tatsächlichen Zeitversatz zwischen den jeweiligen lokalen Zeitgebern angibt, und ein Zeitfehler-Signal zu erzeugen, wenn bei der Überprüfung eine fehlerhafte Zeitversatzinformation erkannt wird.

Hinsichtlich der erfindungsgemäßen Differentialschutzeinrichtung bzw. des erfindungsgemäßen Differentialschutzsystems gelten alle zu dem erfindungsgemäßen Differentialschutzverfahren voranstehend und nachfolgend gemachten Ausführungen und umgekehrt in entsprechender Weise, insbesondere sind die erfindungsgemäße Einrichtung und das erfindungsgemäße System zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen:

Figur 1    eine schematische Ansicht eines Differentialschutzsystems zur Überwachung einer Leitung eines elektrischen Energieversorgungsnetzes;

Figur 2    ein Diagramm zur Erläuterung der Ermittlung eines Vergleichs-Phasenwinkels;

Figur 3    ein Diagramm zur Erläuterung der Verwendung eines Toleranzbereichs um den Vergleichs-Phasenwinkel.

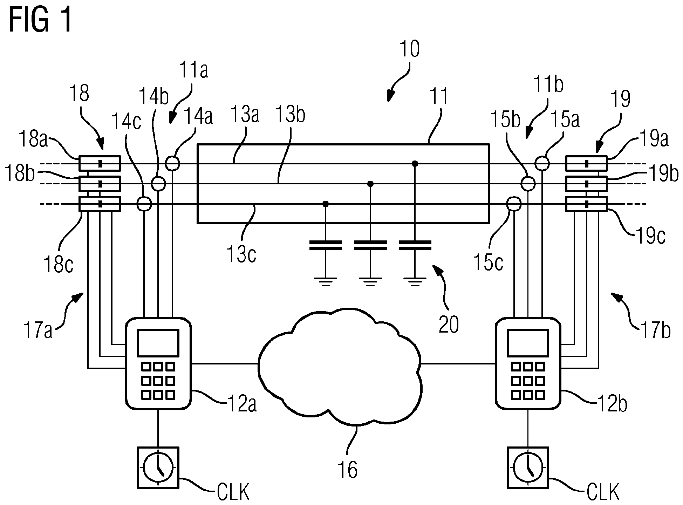

Figur 1 zeigt einen Teil 10 eines im Weiteren nicht näher dargestellten elektrischen Energieversorgungsnetzes. Der Teil 10 umfasst eine dreiphasige Leitung 11, die beispielsweise als Freileitung oder als Kabel ausgebildet sein kann. Die Leitung 11 wird an ihrem ersten Ende 11a mittels einer ersten Differentialschutzeinrichtung 12a und an ihrem zweiten Ende 11b mittels einer zweiten Differentialschutzeinrichtung 12b hinsichtlich auf der Leitung auftretender Fehler, z.B. Kurzschlüsse, überwacht. Hierfür werden für jede Phase 13a, 13b, 13c der Leitung 11 mit ersten Stromwandlern 14a-c an einer ersten Messstelle an dem ersten Ende 11a der Leitung 11 und zweiten Stromwandlern 15a-c an einer zweiten Messstelle an dem zweiten Ende 11b der Primärkomponente 11 Stromsignale erfasst und einer jeweiligen Messeinrichtung der Differentialschutzeinrichtungen 12a, 12b zugeführt. Aus den analogen Stromsignalen werden Stromzeigermesswerte erzeugt, die eine Angabe von Amplitude und Phasenwinkel des Stromsignals zum Erfassungszeitpunkt angeben. Die Erzeugung der Stromzeigermesswerte inklusive einer A/D-Wandlung kann in der Messeinrichtung der jeweiligen Differentialschutzeinrichtung 12a, 12b, in den Stromwandlern selbst oder in einem geeigneten Messgerät, z.B. einer Phasor Measurement Unit (PMU), einer Remote Terminal Unit (RTU) oder einer Merging Unit erfolgen.

Letztlich werden die erzeugten Stromzeigermesswerte einer Auswerteeinrichtung, z.B. einer CPU oder einem Signalprozessor, der jeweiligen Differentialschutzeinrichtung 12a, 12b zugeführt.

Die Differentialschutzeinrichtungen 12a bzw. 12b sind durch eine in Figur 1 nur schematisch angedeutete Kommunikationsverbindung 16 miteinander verbunden, bei der es sich z.B. um ein IP-basiertes Kommunikationsnetz oder ein Telekommunikationsnetz handeln kann. Allerdings kann auch jede weitere Kommunikationsverbindung beliebiger Art zur Verbindung der Differentialschutzeinrichtungen 12a und 12b eingesetzt werden. Über diese Kommunikationsverbindung 16 können der jeweiligen Differentialschutzeinrichtung 12a bzw. 12b die Stromzeigermesswerte vom jeweils anderen Ende 11a, 11b der Leitung 11 zur Verfügung gestellt werden, das heißt, es können in jeder Differentialschutzeinrichtung 12a bzw. 12b für jede Phase 13a, 13b, 13c der Leitung 11 jeweils Paare aus an beiden Enden 11a und 11b aufgenommenen Stromzeigermesswerten gebildet werden.

Anhand der in beiden Differentialschutzeinrichtungen 12a und 12b verfügbaren Strommesswerte von beiden Enden 11a und 11b der Primärkomponente 11 kann in einer oder beiden Differentialschutzeinrichtungen 12a bzw. 12b mittels der Auswerteeinrichtung durch vektorielle Addition der Stromzeigerwerte und anschließende Betragsbildung pro Phase ein Differenzstromwert gebildet und mit einem Schwellenwert verglichen werden.

Bei fehlerfreier Leitung 11 ist der pro Phase in die Leitung 11 eintretende Strom nahezu gleich dem aus der Leitung 11 austretenden Strom, so dass sich bei vektorieller Addition der Stromzeigermesswerte ein Zeiger mit dem Betrag von etwa Null ergeben müsste. Aufgrund des Ladestroms auf der überwachten Leitung nimmt der Differenzstromzeigerwert auch im fehlerfreien Falle allerdings quasi nie dauerhaft exakt den Wert Null an, sondern liegt stattdessen unterhalb eines vorgegebenen Schwellenwertes. Daneben können auch beispielsweise von Wandlerungenauigkeiten und Messfehler zu diesem Effekt beitragen. Der vorgegebene Schwellenwert kann entweder statisch oder dynamisch, beispielsweise an die Höhe der jeweiligen Phasenströme angepasst, festgelegt werden.

Der Schwellenwert kann als separater Parameter festgelegt sein. Es kann jedoch auch vorgesehen sein, eine Schwellenwertüberschreitung durch Auswertung der Lage eines Messwertpaares aus dem Differenzstromwert und einem zugehörigen Stabilisierungswert in einem Auslösediagramm zu prüfen. Hierzu werden aus zusammengehörenden, d.h. gleichzeitig erfassten, Stromzeigermesswerten Differenzstromwerte und zugehörige Stabilisierungswerte gebildet und die Lage des aus einem Differenzstromwert und einem Stabilisierungswert bestehenden Messwertpaares in dem Auslösediagramm geprüft. Liegt das Messwertpaar innerhalb eines Auslösebereichs, wird auf einen Fehler hinschlicht der überwachten Leitung geschlossen und das Fehlersignal erzeugt.

Überschreitet für eine bestimmte Phase der Differenzstromwert den vorgegebenen Schwellenwert, so weist dies auf einen Fehler hinsichtlich der betreffenden Phase der Leitung 11 hin, bei dem es sich beispielsweise um einen Kurzschluss mit Erdbeteiligung oder einen zwei- oder mehrpoligen Kurzschluss, d.h. einen Kurzschluss zwischen zwei oder mehr Phasen der Primärkomponente, handeln kann. Für diejenige Phase, bei der der Fehler erkannt worden ist, erzeugen die Differentialschutzeinrichtungen 12a und 12b ein Fehlersignal, wodurch die Abgabe eines Auslösesignals über Steuerleitungen 17a, 17b an phasenselektiv schaltbare Leistungsschalter 18 bzw. 19 bewirkt wird. Das Auslösesignal veranlasst den entsprechenden phasenbezogenen Leistungsschalter 18a, 18b, 18c bzw. 19a, 19b, 19c zum Öffnen seiner Schaltkontakte, so dass die von dem Fehler betroffene Phase 13a, 13b, 13c vom restlichen Energieversorgungsnetz abgetrennt wird.

Liegt beispielsweise auf der Phase 13b ein Kurzschluss mit Erdbeteiligung vor, so erkennen die Differentialschutzeinrichtungen 12a bzw. 12b dies anhand eines den jeweiligen Schwellenwert übersteigenden Differenzstromwertes und geben Auslösesignale an die phasenbezogenen Leistungsschalter 18b bzw. 19b ab, um die Phase 13b der Leitung 11 von dem Energieversorgungsnetz abzutrennen.

Obwohl gemäß Figur 1 eine dreiphasige Leitung 11 mit lediglich zwei Enden 11a bzw. 11b gezeigt ist, kann das erfinderische Verfahren auch bei beliebigen ein- oder mehrphasigen Leitungen mit zwei oder mehr Enden, beispielsweise elektrischen Sammelschienen mit mehreren Abzweigen, eingesetzt werden.

Außerdem kann in Abweichung zur Darstellung gemäß Figur 1 auch vorgesehen sein, dass die Stromzeigermesswerte zu einer einzigen Differentialschutzeinrichtung übertragen und dort ausgewertet werden. In diesem Fall reicht es aus, an den Enden 11a, 11b der Leitung 11 Messeinrichtungen zu platzieren, die die Stromzeigermesswerte erfassen und an die Differentialschutzeinrichtung übermitteln. Diese Differentialschutzeinrichtung könnte an einem der Leitungsenden, aber auch an beliebiger anderer Stelle, beispielsweise als zentrale Differentialschutzeinrichtung in einer Schaltanlagenstation oder einer Leitstelle, angeordnet sein.

Um den Differenzstromwert korrekt ermitteln zu können, ist es notwendig, dass die zu seiner Bildung verwendeten Stromzeigermesswerte tatsächlich gleichzeitig an den Enden 11a, 11b der Leitung 11 erfasst worden sind. Üblicherweise stellt sich jedoch, insbesondere bei der Übertragung der Stromzeigermesswerte über eine vergleichsweise lange Kommunikationsstrecke, eine zeitliche Verzögerung ein, so dass der lokal erfasste Stromzeigermesswert nicht ohne weiteres einem an einem entfernten Ende erfassten und übertragenen Stromzeigermesswert verknüpft werden kann. Bei Verwendung nicht gleichzeitig erfasster Stromzeigermesswerte können sich auch bei eigentlich fehlerfreier Leitung Differenzstromwerte ergeben, die den Schwellenwert überschreiten und damit zur Abgabe eines Fehlersignals führen würden.

Zur zeitlichen Zuordnung der Stromzeigermesswerte werden diese daher üblicherweise mit einer Markierung in Form eines Zeitstempels versehen, der den Zeitpunkt ihrer Erfassung angibt. Durch Auswahl derjenigen Stromzeigermesswerte von unterschiedlichen Enden der Leitung, die einen zueinander passenden Zeitstempel aufweisen, kann sichergestellt werden, dass der Differenzstromwert korrekt berechnet wird. Diese Vorgehensweise setzt jedoch voraus, dass die zur Erfassung der Stromzeigermesswerte verwendeten Messeinrichtungen jeweils lokale Uhren bzw. Zeitgeber (CLK) aufweisen, die miteinander synchronisiert sind oder zumindest einen bekannten Zeitversatz aufweisen. Um dies zu erreichen, findet eine kontinuierliche Ermittlung eines etwaigen Zeitversatzes zwischen den Zeitgebern (CLK) der jeweiligen Messeinrichtungen statt, der entweder zur Nachjustierung eines Zeitgebers (CLK) oder von der Auswerteeinrichtung der Differentialschutzeinrichtung zur zeitlichen Zuordnung der Stromzeigermesswerte verwendet wird. Im letztgenannten Fall muss zur zeitlichen Zuordnung der Stromzeigermesswerte der ermittelte Zeitversatz von dem Zeitstempel des Stromzeigermesswertes derjenigen Messeinrichtung abgezogen werden, die den Zeitgeber mit der im Vergleich zum anderen Zeitgeber (CLK) vorgehenden Uhrzeit aufweist.

Um den Zeitversatz zwischen den Zeitgebern (CLK) der Messeinrichtungen zu ermitteln, kann z.B. das sogenannte "Ping-Pong-Verfahren" eingesetzt werden. Dabei wird diejenige Zeitdauer gemessen, die benötigt wird, um über die Übertragungsstrecke zwischen den beiden Messeinrichtungen ein erstes Telegramm in die eine Richtung und anschließend ein zweites Telegramm in die andere Richtung zu übertragen. Die übertragenen Telegramme weisen jeweils einen Zeitstempel auf, der den Zeitpunkt ihres Versendens angibt. Außerdem halten die Messeinrichtungen den Empfangszeitpunkt des jeweiligen Telegramms fest. Anhand der Zeitstempel kann die Zeitdauer für die reine Übertragung der Telegramme (ohne etwaige Zeitverzögerungen zwischen dem Empfang des ersten Telegramms und dem Versenden des zweiten Telegramms) ermittelt werden. Die ermittelte Zeitdauer wird halbiert und ergibt die Laufzeit auf der Kommunikationsstrecke für ein in eine Übertragungsrichtung übertragenes Telegramm. Anhand der mit den Telegrammen übertragenen Zeitstempel sowie den Empfangszeitpunkten und der nunmehr bekannten Laufzeit können die Messeinrichtungen den Zeitversatz zwischen den Zeitgebern (CLK) der Messeinrichtungen bestimmen. Weitere Details zum Ping-Pong-Verfahren finden sich in der eingangs genannten US 8,154,836 B2.

Die Ermittlung des Zeitversatzes kann jedoch nur dann zuverlässige Ergebnisse liefern, wenn die Kommunikationsstrecke zwischen den Messeinrichtungen symmetrisch ist, d.h., wenn die Laufzeiten der Telegramme für den Hinweg und den Rückweg über die Kommunikationsstrecke gleich sind. Bei einer unsymmetrischen Kommunikationsstrecke, d.h. ungleichen Laufzeiten für den Hin- und Rückweg, liefert das Ping-Pong-Verfahren eine nicht korrekte Laufzeit, so dass der unter Verwendung der Laufzeit ermittelte Zeitversatz auch fehlerhaft ist. In diesem Fall werden für die Berechnung des Differenzstromzeigerwertes fälschlicherweise nicht gleichzeitig erfasste Stromzeigermesswerte verwendet. Dies kann im ungünstigsten Fall in der Ermittlung eines Differenzstromzeigerwertes resultieren, der - trotz eigentlich fehlerfreier Leitung - den Schwellenwert übersteigt.

Es ist daher sicherzustellen, dass eine umgehende Erkennung erfolgt, wenn eine Kommunikationsstrecke von Anfang an unsymmetrisch ist oder sich von einer symmetrischen Kommunikationsstrecke - schleichend oder sprunghaft - zu einer unsymmetrischen Kommunikationsstrecke wandelt. Beispielsweise kann eine zuvor symmetrische Kommunikationsstrecke durch Schaltvorgänge von Switches oder Routern, die den Kommunikationspfad eines Telegramms verändern, ein unsymmetrisches Verhalten annehmen. Auch können sich Alterungseffekte oder Topologieänderungen auf das Verhalten einer Kommunikationsstrecke auswirken.

Alternativ kann die Laufzeit auch entsprechend dem in der Norm IEEE 1588 definierten "Precision Time Protocol" (PTP) ermittelt werden.

Gemäß dem vorgeschlagenen Verfahren kann das Vorliegen eines unsymmetrischen Verhaltens einer Kommunikationsstrecke bzw. anderer die Laufzeitmessung verfälschender Umstände vergleichsweise einfach erkannt werden. Hierzu werden lediglich ohnehin durch Messung oder Parametrierung in einer Differentialschutzeinrichtung vorhandene elektrische Größen und leitungsspezifische Parameter benötigt.

Für die nachfolgenden Erläuterungen wird angenommen, dass als elektrische Messgrößen die Amplituden von - über den ermittelten Zeitversatz - zeitlich einander zugeordneten Stromzeigermesswerten sowie als leitungsspezifischer Parameter ein den Ladestrom der Leitung zwischen den beiden Messeinrichtungen angebender Ladestromwert verwendet wird.

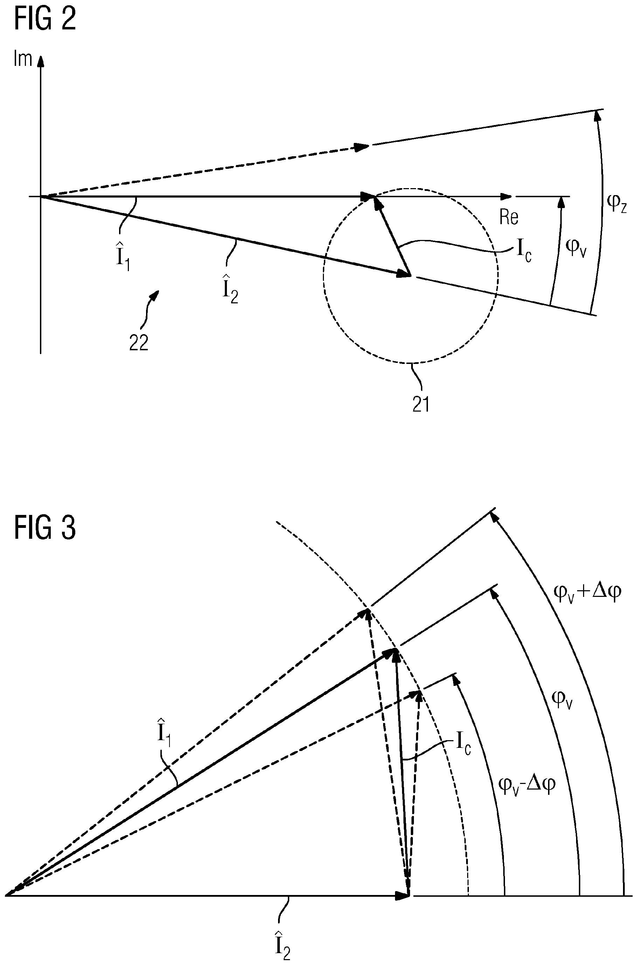

Die Funktionsweise des Verfahrens wird unter Hinzunahme von Figur 2 näher erläutert. Zur Erkennung des Eintritts eines unsymmetrischen Verhaltens hinsichtlich der Kommunikationsstrecke oder eines anderen eine Laufzeitmessung verfälschenden Umstands wird die Erkenntnis verwendet, dass der in die Leitung hineinfließende Strom der Summe des aus der Leitung hinausfließenden Stroms und des durch den kapazitiven Effekt der Leitung verursachten Ladestroms (in Figur 1 schematisch durch Leitungskapazitäten 20 angedeutet) entsprechen muss. Dieser Ladestrom ist - wie der eingangs dargestellten Gleichung zur Ermittlung des Ladestromwertes $I_C$ - entnehmbar ist, unter anderem abhängig von der Länge der Leitung und fällt somit insbesondere bei Leitungen mit mehreren Kilometern Länge ins Gewicht.

Aus zeitlich tatsächlich zueinander gehörenden Stromzeigermesswerten und dem den Ladestrom angebenden Ladestromwert muss sich somit ein Dreieck konstruieren lassen, dessen zwischen den Stromzeigermesswerten eingeschlossener Winkel dem Zeitversatz zwischen den beiden Messeinrichtungen entspricht.

Dies lässt sich dazu einsetzen, eine Plausibilitätsprüfung des (z.B. über das Ping-Pong-Verfahren) ermittelten Zeitversatzes vorzunehmen. Hierzu werden lediglich die Amplituden, nicht jedoch die Phaseninformation, der über den zu überprüfenden Zeitversatz vermeintlich zueinander gehörenden Stromzeigermesswerte $\hat{I}_1$ und $\hat{I}_2$ verwendet (vgl. Figur 2). Diese werden unter Verwendung des Betrags des Ladestromwertes $I_C$ so weit aufgespannt, dass ein Zeiger mit einer dem Betrag des Ladestromwertes entsprechenden Länge zwischen den Zeigerspitzen der beiden Amplituden $\hat{I}_1$ und $\hat{I}_2$ platziert werden kann. Diese Vorgehensweise ist in Figur 2 dadurch bildhaft angedeutet, dass um die Zeigerspitze der Amplitude $\hat{I}_2$ ein Kreis 21 mit dem Radius des Betrags des Ladestroms $I_C$ geschlagen ist. Die Amplitude $\hat{I}_1$ wird daraufhin so platziert, dass ihre Zeigerspitze auf dem Kreisumfang zu liegen kommt. Somit ergibt sich die vektorielle Summe aus einem Stromzeigermesswert mit der Amplitude $\hat{I}_1$ und der Differenz aus einem Stromzeigermesswert mit der Amplitude $\hat{I}_2$ und dem Ladestromwert $I_C$. Diese hier zum besseren Verständnis bildhaft dargestellte Vorgehensweise wird in der Praxis üblicherweise numerisch gelöst.

Aus dem auf diese Weise entstehenden Dreieck 22 kann der zwischen den beiden Amplituden $\hat{I}_1$ und $\hat{I}_2$ liegende Winkel ermittelt und als Vergleichs-Phasenwinkel $\varphi_V$ verwendet werden.

Dieser Vergleichs-Phasenwinkel $\varphi_V$ wird mit einem aus dem vermeintlichen Zeitversatz abgeleiteten Zeitversatz-Phasenwinkel $\varphi_Z$ verglichen. Dieser Zeitversatz-Phasenwinkel $\varphi_Z$ kann aus der den Zeitversatz angebenden Zeitversatzinformation und der durch die Frequenz festgelegten Kreisfrequenz einfach berechnet werden.

Sofern der Zeitversatz-Phasenwinkel $\varphi_Z$ den tatsächlichen Zeitversatz zwischen den Zeitgebern der beiden Messeinrichtungen angibt, entsprechen sich die Werte des Zeitversatz-Phasenwinkels $\varphi_Z$ und des Vergleichs-Phasenwinkels $\varphi_V$. In diesem Fall ist die Kommunikationsstrecke symmetrisch und die Zeigermesswerte sind korrekt einander zugeordnet worden und können zur Berechnung des Differenzstromwertes verwendet werden. Sofern dieser über dem Schwellenwert liegt, ist von einem tatsächlichen Fehler auf der Leitung auszugehen, der eine Abschaltung erforderlich macht.

Sofern der Zeitversatz-Phasenwinkel $\varphi_Z$ hingegen nicht den tatsächlichen Zeitversatz zwischen den Zeitgebern der beiden Messeinrichtungen angibt, besteht - wie in Figur 2 beispielhaft dargestellt - eine Abweichung zwischen den Werten des Zeitversatz-Phasenwinkels $\varphi_Z$ und des Vergleichs-Phasenwinkels $\varphi_V$. Dies bedeutet, dass der ermittelte Zeitversatz und die Amplituden $\hat{I}_1$, $\hat{I}_2$ der beiden Stromzeigermesswerte nicht zueinander passen. Dies kann mit hoher Wahrscheinlichkeit darauf zurückgeführt werden, dass die zur Ermittlung des Zeitversatzes verwendete Laufzeit z.B. aufgrund eines unsymmetrischen Verhaltens der Kommunikationsstrecke nicht korrekt bestimmt werden konnte.

Sofern eine Abweichung zwischen dem Zeitversatz-Phasenwinkel $\varphi_Z$ und dem Vergleichs-Phasenwinkel $\varphi_V$ festgestellt worden ist, dürfen die Stromzeigermesswerte nicht ohne weiteres für die Ermittlung des Differenzstromwertes herangezogen werden, da sonst die Gefahr besteht, dass ein Fehler auf der Leitung erkannt wird, der in Wirklichkeit überhaupt nicht vorliegt. Bei Vorliegen einer solchen Abweichung wird daher ein Zeitfehler-Signal erzeugt.

Das Zeitfehler-Signal kann beispielsweise dazu verwendet werden, die Abgabe des einen Fehler auf der Leitung angebenden Fehlersignals zu blockieren. Hierdurch kann zuverlässig eine ungewollte Abschaltung der Leitung verhindert werden. Alternativ kann bei Vorliegen des Zeitfehler-Signals auch der zur Bewertung des Differenzstromwertes herangezogene Schwellenwert erhöht werden. Neben einer Erhöhung eines einzelnen Schwellenwertes kann dies beispielsweise auch durch entsprechende Änderung eines Verlaufs einer Grenzkurve in einem Auslösediagramm erfolgen. Hierdurch wird quasi die Empfindlichkeit des Differentialschutzverfahrens herabgesetzt, ein Fehlersignal wird nur noch bei vergleichsweise großen Differenzstromwerten erzeugt.

Da in der Praxis neben möglichen Ungenauigkeiten bei der Ermittlung des Zeitversatzes auch weitere Effekte, wie Mess- oder Rechenungenauigkeiten bei der Ermittlung der Stromzeigermesswerte, auftreten können, sollte eine etwaige Abweichung zwischen dem Zeitversatz-Phasenwinkel $\varphi_Z$ und dem Vergleichs-Phasenwinkel $\varphi_V$ mit einem Toleranz-Schwellenwert verglichen werden. Hierdurch kann das Verfahren gegen kleinere Schwankungen und Ungenauigkeiten stabilisiert werden. Dies ist beispielhaft in Figur 3 angedeutet. Hier wird durch gestrichelte Zeiger um den Wert des auf die oben beschriebene Weise ermittelten Vergleichs-Phasenwinkels $\varphi_V$ ein Toleranzbereich $\varphi_V \pm \Delta\varphi$ erzeugt. Sofern der Zeitversatz-Phasenwinkel $\varphi_Z$ innerhalb des Toleranzbereiches liegt, wird der durch ihn angegebene Zeitversatz als korrekt angesehen und es wird kein Zeitfehler-Signal erzeugt. Liegt der Zeitversatz-Phasenwinkel $\varphi_Z$ hingegen außerhalb des Toleranzbereiches wird das Zeitfehler-Signal erzeugt.

Die obigen Ausführungen beziehen sich darauf, zwei Winkelgrößen miteinander zu vergleichen. In entsprechender Weise kann gemäß einer alternativen Ausführungsform auch ein Vergleich zweier Zeitgrößen durchgeführt werden, indem aus dem Vergleichs-Phasenwinkel bei Kenntnis der Kreisfrequenz eine entsprechende Vergleichs-Zeitversatzinformation berechnet wird, die dem durch den Vergleichs-Phasenwinkel angegebenen Zeitversatz entspricht. Diese Vergleichs-Zeitversatzinformation wird daraufhin mit der z.B. aus dem Ping-Pong-Verfahren bekannten Zeitversatzinformation verglichen und bei Vorliegen einer Abweichung wird das Zeitfehler-Signal erzeugt. Die übrigen oben gemachten Ausführungen können entsprechend auf diese Ausführungsform angewendet werden.

Das beschriebene Verfahren kann auch bei einer mehr als zwei Enden aufweisende Leitung angewendet werden. In diesem Fall wird die Überprüfung der Zeitversatzinformation jeweils anhand von zwei Stromzeigermesswerten unterschiedlicher Enden und des Ladestroms hinsichtlich des zwischen diesen Enden liegenden Abschnitts der Leitung durchgeführt.

Die obigen Ausführungen können im Wesentlichen auch auf die Überprüfung einer Zeitversatz-Information unter Verwendung anderer elektrischer Messgrößen (z.B. Spanungszeiger bzw. Lastflüsse als Produkte aus Strom- und Spannungszeigern) und leitungsspezifischer Parameter (Leitungslänge und/oder Ausbreitungskonstante) übertragen werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Differentialschutzverfahren zum Überwachen einer Leitung (11) eines elektrischen Energieversorgungsnetzes, bei dem

 - an den Enden (11a, 11b) der Leitung (11) jeweils mit Messeinrichtungen Stromzeigermesswerte erfasst werden, die Amplitude und Phasenwinkel eines an dem jeweiligen Ende (11a, 11b) der Leitung (11) fließenden Phasenstroms angeben, wobei die Messeinrichtungen lokale Zeitgeber (CLK) aufweisen und den Stromzeigermesswerten einen den Zeitpunkt ihrer Erfassung angebenden Zeitstempel zuordnen;
 - zumindest die an einem Ende erfassten Stromzeigermesswerte über eine Kommunikationsverbindung (16) zu einer Auswerteeinrichtung übertragen werden;
 - mittels der Auswerteeinrichtung mit zeitlich einander zugeordneten Stromzeigermesswerten durch vektorielle Addition ein Differenzstromwert gebildet wird, wobei zur zeitlichen Zuordnung der an unterschiedlichen Enden (11a, 11b) erfassten Stromzeigermesswerte eine den Zeitversatz zwischen den lokalen Zeitgebern (CLK) der Messeinrichtungen angebende Zeitversatzinformation herangezogen wird; und
 - ein einen Fehler hinsichtlich der Leitung (11) angebendes Fehlersignal erzeugt wird, wenn der Differenzstromwert einen vorgegebenen Schwellenwert überschreitet;

**dadurch gekennzeichnet, dass**

 - unter Verwendung von zeitlich einander zugeordneten elektrischen Messgrößen, die an unterschiedlichen Enden (11a, 11b) der Leitung (11) erfasst worden sind, und einem bezüglich der zwischen den Enden (11a, 11b) verlaufenden Leitung (11) leitungsspezifischen Parameter eine Überprüfung durchgeführt wird, ob die Zeitversatzinformation den tatsächlichen Zeitversatz zwischen den jeweiligen lokalen Zeitgebern (CLK) angibt, indem unter Verwendung der elektrischen Messgrößen und des leitungsspezifischen Parameters ein Vergleichs-Phasenwinkel ermittelt wird und der Vergleichs-Phasenwinkel zur Überprüfung der Zeitversatzinformation herangezogen wird, wobei der Vergleichs-Phasenwinkel ermittelt wird, indem die zeitlich einander zugeordneten elektrischen Messgrößen um den Betrag des leitungsspezifischen Parameters aufgespannt werden und der zwischen den aufgespannten Amplituden liegende Winkel als Vergleichs-Phasenwinkel verwendet wird; und
 - ein Zeitfehler-Signal erzeugt wird, wenn bei der Überprüfung eine fehlerhafte Zeitversatzinformation erkannt wird.

2. Differentialschutzverfahren nach Anspruch 1, **dadurch gekennzeichnet, dass**

 - als elektrische Messgrößen, die an unterschiedlichen Enden (11a, 11b) der Leitung (11) erfasst worden sind, Amplituden von zeitlich einander zugeordneten Stromzeigermesswerten verwendet werden; und
 - als leitungsspezifischer Parameter ein den Ladestrom bezüglich der zwischen den Enden (11a, 11b) verlaufenden Leitung (11) angebender Ladestromwert verwendet wird.

3. Differentialschutzverfahren nach Anspruch 1 oder Anspruch 2, **dadurch gekennzeichnet, dass**

 - als elektrische Messgrößen, die an unterschiedlichen Enden (11a, 11b) der Leitung (11) erfasst worden sind, zeitlich einander zugeordnete Spannungszeigermesswerte verwendet werden; und
 - als leitungsspezifischer Parameter die Leitungslänge und/oder die Ausbreitungskonstante bezüglich der zwischen den Enden (11a, 11b) verlaufenden Leitung (11) verwendet wird.

4. Differentialschutzverfahren nach einem der vorangehenden Ansprüche, **dadurch gekennzeichnet, dass**

- als elektrische Messgrößen, die an unterschiedlichen Enden (11a, 11b) der Leitung (11) erfasst worden sind, zeitlich einander zugeordnete Produkte von Strom- und Spannungszeigermesswerte verwendet werden; und
- als leitungsspezifischer Parameter die Leitungslänge und/oder die Ausbreitungskonstante bezüglich der zwischen den Enden (11a, 11b) verlaufenden Leitung (11) verwendet wird.

5. Differentialschutzverfahren nach einem der vorangehenden Ansprüche,
**dadurch gekennzeichnet, dass**

- zur Überprüfung der Zeitversatzinformation ein sich aus der Zeitversatzinformation ergebender Zeitversatz-Phasenwinkel ermittelt wird;
- der Zeitversatz-Phasenwinkel mit dem Vergleichs-Phasenwinkel verglichen wird; und
- bei einer vorliegenden Abweichung zwischen dem Zeitversatz-Phasenwinkel und dem Vergleichs-Phasenwinkel das Zeitfehler-Signal erzeugt wird.

6. Differentialschutzverfahren nach einem der Ansprüche 1 bis 4,
**dadurch gekennzeichnet, dass**

- zur Überprüfung der Zeitversatzinformation eine sich aus dem Vergleichs-Phasenwinkel ergebende Vergleichs-Zeitversatzinformation ermittelt wird;
- die Vergleichs-Zeitversatzinformation mit der Zeitversatzinformation verglichen wird; und
- bei einer vorliegenden Abweichung zwischen der Vergleichs-Zeitversatzinformation und der Zeitversatzinformation das Zeitfehler-Signal erzeugt wird.

7. Differentialschutzverfahren nach einem der Ansprüche 5 oder 6,
**dadurch gekennzeichnet, dass**

- das Zeitfehler-Signal nur dann erzeugt wird, wenn die Abweichung einen vorgegebenen Toleranz-Schwellenwert überschreitet.

8. Differentialschutzverfahren nach einem der vorangehenden Ansprüche,
**dadurch gekennzeichnet, dass**

- bei vorliegendem Zeitfehler-Signal die Abgabe des Fehlersignals blockiert wird.

9. Differentialschutzverfahren nach einem der Ansprüche 1-7,
**dadurch gekennzeichnet, dass**

- bei vorliegendem Zeitfehler-Signal der Wert des zur Bewertung des Differenzstromwertes verwendeten Schwellenwertes erhöht wird.

10. Differentialschutzverfahren nach einem der vorangehenden Ansprüche,
**dadurch gekennzeichnet, dass**

- die Zeitversatzinformation derart ermittelt wird, dass über die Kommunikationsverbindung (16) Nachrichten übertragen werden und zur Ermittlung der Zeitversatzinformation der halbe Wert der Zeitdauer der Übertragung einer ersten Nachricht in die eine Übertragungsrichtung und einer zweiten Nachricht in die andere Übertragungsrichtung verwendet wird.

11. Differentialschutzverfahren nach einem der vorangehenden Ansprüche,
**dadurch gekennzeichnet, dass**

- bei einer mehr als zwei Enden aufweisenden Leitung die Überprüfung, ob die Zeitversatzinformation den tatsächlichen Zeitversatz zwischen den jeweiligen lokalen Zeitgebern (CLK) angibt, für jeweils zwei Enden unter Verwendung des leitungsspezifischen Parameters hinsichtlich des zwischen diesen Enden liegenden Leitungsabschnitts durchgeführt wird.

12. Differentialschutzeinrichtung (12a, 12b) zum Überwachen einer Leitung (11) eines elektrischen Energieversorgungsnetzes, mit

- einer einen lokalen Zeitgeber (CLK) aufweisenden Messeinrichtung, die dazu eingerichtet ist, an einem Ende (11a, 11b) der Leitung (11) Stromzeigermesswerte zu erfassen, die Amplitude und Phasenwinkel eines an dem Ende (11a, 11b) der Leitung (11) fließenden Phasenstroms angeben, und den Stromzeigermesswerten einen den Zeitpunkt ihrer Erfassung angebenden Zeitstempel zuzuordnen;
- einer Kommunikationseinrichtung, die dazu eingerichtet ist, Stromzeigermesswerte über eine Kommunikationsverbindung (16) mit einer anderen Differentialschutzeinrichtung (12a, 12b) auszutauschen; und
- einer Auswerteeinrichtung, die dazu eingerichtet ist, mit zeitlich einander zugeordneten eigenen Stromzeigermesswerten einerseits und von der anderen Differentialschutzeinrichtung (12a, 12b) empfangenen Stromzeigermesswerten andererseits durch vorzeichenrichtige Addition einen Differenzstromwert zu bilden, wobei zur zeitlichen Zuordnung der an unterschiedlichen Enden (11a, 11b) erfassten Stromzeigermesswerte eine den Zeitversatz zwischen den lokalen Zeitgebern (CLK) der Messeinrichtungen der Differentialschutzeinrichtungen (12a, 12b) angebende Zeitversatzinformation herangezogen wird, und ein einen Fehler hinsichtlich der Leitung (11) angebendes Fehlersignal zu erzeugen, wenn der Differenzstromwert einen vorgegebenen Schwellenwert überschreitet; **dadurch gekennzeichnet, dass** - die Differentialschutzeinrichtung (12a, 12b) dazu eingerichtet ist, unter Verwendung von zeitlich einander zugeordneten eigenen Messgrößen einerseits und von der anderen Differentialschutzeinrichtung (12a, 12b) empfangenen Messgrößen andererseits und einem leitungsspezifischen Parameter eine Überprüfung durchzuführen, ob die Zeitversatzinformation den tatsächlichen Zeitversatz zwischen den jeweiligen lokalen Zeitgebern (CLK) angibt, indem - unter Verwendung der elektrischen Messgrößen und des leitungsspezifischen Parameters ein Vergleichs-Phasenwinkel ermittelt wird und der Vergleichs-Phasenwinkel zur Überprüfung der Zeitversatzinformation herangezogen wird, wobei der Vergleichs-Phasenwinkel ermittelt wird, indem die zeitlich einander zugeordneten elektrischen Messgrößen um den Betrag des leitungsspezifischen Parameters aufgespannt werden und der zwischen den aufgespannten Amplituden liegende Winkel als Vergleichs-Phasenwinkel verwendet wird; und ein Zeitfehler-Signal zu erzeugen, wenn bei der Überprüfung eine fehlerhafte Zeitversatzinformation erkannt wird.

13. Differentialschutzsystem zum Überwachen einer Leitung (11) eines elektrischen Energieversorgungsnetzes, mit zumindest zwei Differentialschutzeinrichtungen (12a, 12b) nach Anspruch 12, wobei an jedem Ende (11a, 11b) der Leitung (11) eine Differentialschutzeinrichtung (12a, 12b) vorgesehen ist, und mit einer Kommunikationsverbindung (16), mit der die einzelnen Differentialschutzeinrichtungen (12a, 12b) zur Übertragung von Stromzeigermesswerten in Verbindung stehen.

## Claims

1. Differential protection method for monitoring a line (11) of a power grid, in which

   - current indicator measured values are measured in each case with measuring devices at the ends (11a, 11b) of the line (11), said values indicating the amplitude and phase angle of a phase current flowing at the respective end (11a, 11b) of the line (11), wherein the measuring devices have local timers (CLK) and allocate a timestamp to the current indicator measured values indicating the time of their measurement; - at least the current indicator measured values measured at one end are transmitted via a communication connection (16) to an evaluation device; - a differential current value is formed through vectorial addition by means of the evaluation device with current indicator measured values temporally allocated to one another, wherein time delay information indicating the time delay between the local timers (CLK) of the measuring devices is used for the temporal allocation of the current indicator measured values measured at different ends (11a, 11b); and - a fault signal indicating a fault affecting the line (11) is generated if the differential current value exceeds a predefined threshold value; **characterized in that** - a check is carried out using electrical measured quantities temporally allocated to one another which have been measured at different ends (11a, 11b) of the line (11) and a line-specific parameter relating to the line running between the ends (11a, 11b) in order to determine whether the time delay information indicates the actual time delay between the respective local timers (CLK), a comparative phase angle being determined using the electrical measured quantities and the line-specific parameter and using the comparative phase angle to check the time delay information, wherein the comparative phase angle is determined by extending the electrical measured quantities temporally allocated to one another by the amount of the line-specific parameter and using the angle located between the extended amplitudes as the comparative phase angle; and - a time error signal is generated if erroneous time delay information is detected in the check.

2. Differential protection method according to Claim 1, **characterized in that**

   - amplitudes of current indicator measured values temporally allocated to one another are used as electrical measured quantities which have been measured at different ends (11a, 11b) of the line (11); and - a charging current value indicating the charging current relating to the line (11) running between the ends (11a, 11b) is used as the line-specific parameter.

3. Differential protection method according to Claim 1 or Claim 2, **characterized in that**

- voltage indicator measured values temporally allocated to one another are used as electrical measured quantities which have been measured at different ends (11a, 11b) of the line (11), and

- the line length and/or the propagation constant relating to the line (11) running between the ends (11a, 11b) is used as the line-specific parameter.

4.  Differential protection method according to one of the preceding claims,
    **characterized in that**

    - products of current and voltage indicator measured values temporally allocated to one another are used as electrical measured quantities which have been measured at different ends (11a, 11b) of the line (11); and

    - the line length and/or the propagation constant relating to the line (11) running between the ends (11a, 11b) is used as the line-specific parameter.

5.  Differential protection method according to one of the preceding claims,
    **characterized in that**

    - a time delay phase angle derived from the time delay information is determined in order to check the time delay information;

    - the time delay phase angle is compared with the comparative phase angle; and

    - the time error signal is generated if a deviation occurs between the time delay phase angle and the comparative phase angle.

6.  Differential protection method according to one of Claims 1 to 4,
    **characterized in that**

    - comparative time delay information derived from the comparative phase angle is determined in order to check the time delay information;

    - the comparative time delay information is compared with the time delay information; and

    - the time error signal is generated if a deviation occurs between the comparative time delay information and the time delay information.

7.  Differential protection method according to one of Claims 5 and 6,
    **characterized in that**

    - the time error signal is generated only if the deviation exceeds a predefined tolerance threshold value.

8.  Differential protection method according to one of the preceding claims,

**characterized in that**

    - the emission of the fault signal is blocked if the time error signal occurs.

9.  Differential protection method according to one of Claims 1-7,
    **characterized in that**

    - the value of the threshold value used to evaluate the differential current value is increased if the time error signal occurs.

10. Differential protection method according to one of the preceding claims,
    **characterized in that**

    - the time delay information is determined in such a way that messages are transmitted via the communication connection (16) and half the value of the time duration of the transmission of a first message in one transmission direction and a second message in the other transmission direction is used to determine the time delay information.

11. Differential protection method according to one of the preceding claims,
    **characterized in that**

    - in the case of a line having more than two ends, the check to determine whether the time delay information indicates the actual time delay between the respective local timers (CLK) is carried out in each case for two ends using the line-specific parameter relating to the line section located between these ends.

12. Differential protection device (12a, 12b) for monitoring a line (11) of a power grid, with

    - a measuring device having a local timer (CLK) which is configured to measure current indicator measured values at one end (11a, 11b) of the line (11), said values indicating the amplitude and phase angle of a phase current flowing at the end (11a, 11b) of the line (11), and to allocate a timestamp to the current indicator measured values indicating the time of their measurement;

    - a communication device which is configured to exchange current indicator measured values via a communication connection (16) with another differential protection device (12a, 12b); and

    - an evaluation device which is configured to form a differential current value with its own current indicator measured values temporally allocated to one another on the one hand and current indicator measured values received from the other differential protection device (12a, 12b) on the other hand through addition with the correct algebraic sign, wherein time delay information indicating the time delay between the local timers (CLK) of the measuring devices of the differential protection devices (12a, 12b) is used for the temporal allocation of the current indicator measured values measured at different ends (11a, 11b), and to generate a fault signal indicating a fault affecting the line (11) if the differential current value exceeds a predefined threshold value **characterized in that**

- the differential protection device (12a, 12b) is configured to carry out a check using its own measured quantities temporally allocated to one another on the one hand and measured quantities received from the other differential protection device (12a, 12b) on the other hand and a line-specific parameter in order to determine whether the time delay information indicates the actual time delay between the respective local timers (CLK), a comparative phase angle being determined using the electrical measured quantities and the line-specific parameter and using the comparative phase angle to check the time delay information, wherein

- the comparative phase angle is determined by extending the electrical measured quantities temporally allocated to one another by the amount of the line-specific parameter and using the angle located between the extended amplitudes as the comparative phase angle; and to generate a time error signal if erroneous time delay information is detected in the check.

13. Differential protection system for monitoring a line (11) of a power grid, with at least two differential protection devices (12a, 12b) according to Claim 12, wherein a differential protection device (12a, 12b) is provided at each end (11a, 11b) of the line (11), and with a communication connection (16) to which the individual differential protection devices (12a, 12b) are connected in order to transmit current indicator measured values.

**Revendications**

1. Procédé de protection différentielle pour contrôler une ligne (11) d'un réseau d'alimentation en énergie électrique, dans lequel

- on relève aux bouts (11a, 11b) de la ligne (11), respectivement par des dispositifs de mesure, des valeurs de mesure de vecteur de courant, qui indiquent l'amplitude et l'angle de phase d'un courant de phase passant au bout (11a, 11b) respectif de la ligne (11), les dispositifs de mesure ayant des horloges (CLK) locales et associant aux valeurs de vecteur de courant un horodatage indiquant l'instant de leur relevé ;
- on transmet, à un dispositif d'exploitation, par une liaison (16) de communication, les valeurs de mesure de vecteur de courant relevées à un bout ;
- au moyen du dispositif d'exploitation, on forme, par des valeurs de mesure de vecteur de courant associées l'une à l'autre dans le temps, par addition vectorielle, une valeur de courant de différence en tirant parti, pour l'association dans le temps des valeurs de mesure de vecteur de courant relevées aux bouts (11a, 11b) différents, d'une information de décalage de temps indiquant le décalage de temps entre les horloges (CLK) locales des dispositifs de mesure ; et
- on produit un signal de défaut indiquant un défaut concernant la ligne (11), si la valeur de courant de différence dépasse une valeur de seuil donnée à l'avance ;
**caractérisé en ce que**
- en utilisant des grandeurs de mesure électriques associées l'une à l'autre dans le temps, qui ont été relevées à des bouts (11a, 11b) différents de la ligne et un paramètre spécifique à la ligne se rapportant la ligne (11) s'étendant entre les bouts (11a, 11b), on effectue un contrôle du point de savoir si l'information de décalage de temps indique le décalage de temps réel entre les horloges (CLK) locales respectives, en déterminant, en utilisant les grandeurs de mesure électriques et le paramètre spécifique à la ligne, un angle de phase de comparaison et en tirant parti de l'angle de phase de comparaison pour contrôler l'information de décalage de temps, l'angle de phase de comparaison étant déterminé en élevant les grandeurs de mesure électriques associées l'une à l'autre dans le temps du montant du paramètre spécifique à la ligne et en utilisant l'angle entre les amplitudes élevées comme angle de phase de comparaison ; et
- on produit un signal d'erreur de temps, si l'on détecte au contrôle une information de décalage de temps défectueuse.

2. Procédé de protection différentielle suivant la revendication 1,
**caractérisé en ce que**

- on utilise, comme grandeurs de mesure électriques, qui ont été relevées à des bouts (11a, 11b) différents de la ligne (11), des amplitudes de valeurs de mesure de vecteur de courant associées l'une à l'autre dans le temps ; et

- on utilise, comme paramètre spécifique à la ligne, une valeur de courant de charge indiquant le courant de charge se rapportant à la ligne (11) s'étendant entre les deux bouts (11a, 11b).

**3.** Procédé de protection différentielle suivant la revendication 1 ou la revendication 2, **caractérisé en ce que**

- on utilise, comme grandeurs de mesure électriques, qui ont été relevées à des bouts (11a, 11b) différents de la ligne (11), des valeurs de mesure de vecteur de tension associées l'une à l'autre dans le temps ; et
- on utilise, comme paramètre spécifique à a ligne, la longueur de ligne et/ou la constante de propagation se rapportant à la ligne (11) s'étendant entre les bouts (11a, 11b).

**4.** Procédé de protection différentielle suivant l'une des revendications précédentes, **caractérisé en ce que**

- on utilise, comme grandeurs de mesure électriques, qui ont été relevées à des bouts (11a, 11b) différents de la ligne (11), des produits associés l'un à l'autre dans le temps des valeurs de mesure de vecteur de courant et de tension ; et
- on utilise, comme paramètre spécifique à la ligne, la longueur de la ligne et/ou la constante de propagation se rapportant à la ligne (11) s'étendant entre les bouts (11a, 11b).

**5.** Procédé de protection différentielle suivant l'une des revendications précédentes, **caractérisé en ce que**

- pour contrôler l'information de décalage de temps, on détermine un angle de phase de décalage de temps provenant de l'information de décalage de temps ;
- on compare l'angle de phase de décalage de temps à l'angle de phase de comparaison ; et
- s'il y a un écart entre l'angle de phase de décalage de temps et l'angle de phase de comparaison, on produit le signal d'erreur de temps.

**6.** Procédé de protection différentielle suivant l'une des revendications 1 à 4, **caractérisé en ce que**

- pour contrôler l'information de décalage de temps, on détermine une information de décalage de temps de comparaison provenant de l'angle de phase de comparaison ;
- on compare l'information de décalage de temps de comparaison à l'information de décalage de temps ; et
- s'il y a un écart entre l'information de décalage de temps de comparaison et l'information de décalage de temps, on produit le signal d'erreur de temps.

**7.** Procédé de protection différentielle suivant l'une des revendications 5 ou 6, **caractérisé en ce que**

- l'on ne produit le signal d'erreur de temps que si l'écart dépasse une valeur de seuil de tolérance donnée à l'avance.

**8.** Procédé de protection différentielle suivant l'une des revendications précédentes, **caractérisé en ce que**

- si un signal d'erreur de temps est présent, on bloque l'émission du signal de défaut.

**9.** Procédé de protection différentielle suivant l'une des revendications 1 à 7, **caractérisé en ce que**

- si un signal d'erreur de temps est présent, on augmente la valeur du seuil utilisée pour évaluer la valeur de courant de différence.

**10.** Procédé de protection différentielle suivant l'une des revendications précédentes, **caractérisé en ce que**

- on détermine l'information de décalage de temps de manière à transmettre des messages par la liaison (16) de communication et, pour la détermination de l'information de décalage de temps, on utilise la moitié de la valeur de la durée de la transmission d'un premier message dans un sens de transmission et d'un deuxième message dans l'autre sens de transmission.

**11.** Procédé de protection différentielle suivant l'une des revendications précédentes, **caractérisé en ce que**

- pour une ligne ayant plus de deux bouts, on effectue le contrôle du point de savoir si l'information de décalage de temps indique le décalage de temps réel entre les horloges (CLK) locales respectives pour, respectivement, deux bouts, en utilisant le paramètre spécifique à la ligne se rapportant au tronçon de ligne se trouvant entre ces bouts.

**12.** Dispositif (12a, 12b) de protection différentielle pour le contrôle d'une ligne (11) d'un réseau d'alimentation en énergie électrique, comprenant

- un dispositif de mesure, qui a une horloge (CLK) locale et qui est conçu pour relever, à un bout (11a, 11b ) de la ligne (11), des valeurs de mesure de vecteur de courant, qui indiquent l'amplitude et l'angle de phase d'un courant de phase passant au bout (11a, 11b) de la ligne (11) et pour associer, aux valeurs de mesure de vecteur de courant, un horodatage indiquant l'instant de leur relevé ;

- un dispositif de communication conçu pour échanger, par la liaison (16) de communication, des valeurs de mesure de vecteur de courant avec un autre dispositif (12a, 12b) de protection différentielle ; et

- un dispositif d'exploitation conçu pour former, par addition correcte en signe d'une valeur de courant de différence, par des valeurs de mesure de vecteur de courant propres associées l'une à l'autre dans le temps d'une part et des valeurs de mesure de vecteur de courant reçues de l'autre dispositif (12a, 12b) de protection différentielle d'autre part, dans lequel, pour l'association dans le temps des valeurs de mesure de vecteur de courant relevées à des bouts (11a, 11b) différents, on tire parti d'une information de décalage de temps indiquant le décalage de temps entre les horloges (CLK) locales des dispositifs de mesure des dispositifs (12a, 12b) de protection différentielle, et pour produire un signal de défaut indiquant un défaut en ce qui concerne la ligne, si la valeur de différence de courant dépasse une valeur de seuil donnée à l'avance ;

**caractérisé en ce que**

- le dispositif (12a, 12b) de protection différentielle est conçu pour, en utilisant des grandeurs de mesure propres associées l'une à l'autre dans le temps d'une part et des grandeurs de mesure reçues de l'autre dispositif (12a, 12b) de protection différentielle d'autre part et un paramètre spécifique à la ligne, effectuer un contrôle sur le point de savoir si l'information de décalage de temps indique le décalage de temps réel entre les horloges (CLK) locales respectives, en - en utilisant les grandeurs de mesure électriques et le paramètre spécifique à la ligne - déterminant un angle de phase de comparaison et en tirant parti de l'angle de phase de comparaison pour contrôler l'information de décalage de temps, l'angle de phase de comparaison étant déterminé en élevant les grandeurs de mesure électriques pouvant être associées l'une à l'autre dans le temps du montant du paramètre spécifique à la ligne et en utilisant l'angle entre les amplitudes élevées, comme angle de phase de comparaison ; et pour produire un signal d'erreur de temps si, dans le contrôle, on détecte une information de décalage de temps défectueuse.

**13.** Système de protection différentielle pour contrôler une ligne (11) d'un réseau d'alimentation en énergie électrique, comprenant au moins deux dispositifs (12a, 12b) de protection différentielle suivant la revendication 12, dans lequel, à chaque bout (11a, 11b) de la ligne (11), est prévu un dispositif (12a, 12b) de protection différentielle, et comprenant une liaison (16) de communication, par laquelle les divers dispositifs (12a, 12b) de protection différentielle sont en liaison pour la transmission de valeurs de mesure de vecteur de courant.

FIG 1

## FIG 2

## FIG 3

**IN DER BESCHREIBUNG AUFGEFÜHRTE DOKUMENTE**

**In der Beschreibung aufgeführte Patentdokumente**

- US 8154836 B2